# EUROPÄISCHE PATENTSCHRIFT

(11) **EP 1 006 593 B1**
(45) Veröffentlichungstag und Bekanntmachung des Hinweises auf die Patenterteilung: **16.10.2002**
(21) Anmeldenummer: 99123015.2
(22) Anmeldetag: 19.11.1999
(51) Int. Cl.: H01L 31/048

(54) **Photovoltaisches Solarmodul in Plattenform**
Photovoltaic solar module in a plate form
Module solaire photovoltaique en form de plaque

(30) Priorität: 04.12.1998 DE 19856011; 09.03.1999 DE 19910532
(43) Veröffentlichungstag der Anmeldung: 07.06.2000
(73) Patentinhaber: PILKINGTON Solar International GmbH, 50667 Köln (DE)
(72) Erfinder: Wambach, Karsten, Dr., 40885 Ratingen (DE); Brzoska, Christof, 45309 Essen (DE); Nava, Paul, 53844 Troisdorf (DE)
(74) Vertreter: Tönhardt, Marion, Dr.

(56) Entgegenhaltungen:
- EP-A- 0 325 369
- EP-A- 0 855 750
- DE-A- 4 140 683
- FR-A- 2 362 494

## Beschreibung

Die Erfindung betrifft ein photovoltaisches Solarmodul in Plattenform, mit einer Außenplatte, einer Innenplatte und einer diese verbindenden Zwischenschicht aus Kunststoff, in der Solarzellen eingebettet sind, wobei die Solarzellen über mehrere Verbindungsleiter elektrisch miteinander verschaltet sind und wobei die Verbindungsleiter jeweils mit einer in einer Öffnung in der Innenplatte angeordneten Anschlußeinrichtung elektrisch leitend verbunden sind.

Photovoltaische Solarmodule des vorgenannten Aufbaus sind aus einer Vielzahl von Veröffentlichungen bekannt und werden in zunehmendem Umfang in der Praxis eingesetzt, zum Beispiel für photovoltaische Fassaden- und Dachelemente oder zum Laden von Akkumulatoren. Bei plattenförmigen Solarmodulen, die eben oder auch gebogen sein können, besteht die zur Sonne gewandte Außenplatte meist aus anorganischen Glasscheiben, vorzugsweise aus hoch lichtdurchlässigem Glas mit besonders niedrigem Eisengehalt, das auch als Weißglas bezeichnet wird. Die Außenplatte kann aber auch aus organischem Glas (Kunststoff) bestehen. Für die Innenplatte sind meist aus Stabilitäts- und Haltbarkeitsgründen ebenfalls Glasscheiben aus anorganischem Glas vorgesehen, wobei aber auch andere für diesen Zweck geeignete Materialien wie z.B. lichtundurchlässige, ggfs. metallisierte Kunststoffolien oder Folienlaminate zum Einsatz kommen.

Für die die Platten verbindende Zwischenschicht werden vor allem die zur Herstellung von Verbundglasscheiben bekannten Materialien verwendet, insbesondere im Rahmen eines Verbundprozesses im Autoklaven aufgeschmolzene Folien aus Polyvinylbutyral (PVB) oder Ethylenvinylacetat (EVA). Eine andere Produkt- und Herstellungsvariante sieht vor, daß eine niedrigviskose flüssige Monomer-Mischung zwischen die Platten des Solarmoduls eingebracht und dort polymerisiert wird. Die Zwischenschicht dient in jedem Falle dazu, die zwischen der Innenplatte und der Außenplatte angeordneten Solarzellen zu fixieren und sie zumindest einseitig einzubetten.

Dabei werden einzelne Solarzellen üblicherweise mit Hilfe von schmalen Verbindungsleitem untereinander zu sogenannten Zellenstrings elektrisch verschaltet und mechanisch verbunden, die im Zuge der Modulherstellung gemeinsam zwischen die Platten des Solarmoduls eingelegt werden. Zum elektrischen Verbinden der Solarmodule mit anderen Solarmodulen, mit dem Stromnetz oder direkt mit einem Verbraucher ist es außerdem erforderlich, daß die Verbindungsleiter der einzelnen Zellenstrings jeweils mit einer nach der Modulfertigstellung von außen zugänglichen Anschlußeinrichtung elektrisch leitend verbunden werden. Zu einem Zellenstring gehören normalerweise zwei Verbindungsleiter. Für ein Solarmodul werden in der Regel mehrere Zellenstrings verwendet, die mit geringem Abstand nebeneinander zwischen den Platten angeordnet werden.

Für die Verbindungsleiter werden üblichenweise verzinnte Kupferflachleiter in einer Breite von maximal etwa 5 mm verwendet.

Aus der Praxis ist ein Solarmodul bekannt, beim dem die zu acht oder zehn Zellenstrings gehörenden sechs Verbindungsleiter zu je einer Bohrung in der von einer Glasscheibe gebildeten Innenplatte geführt werden. In diesen sechs Bohrungen sind metallische Anschlußhülsen befestigt, wobei die Verbindung der Anschlußhülsen mit den einzelnen Verbindungsleitem durch Löten oder Schweißen hergestellt wird. Diese Modulanschlußtechnik ist wegen der großen Zahl von Bohrungen fertigungstechnisch aufwendig.

Aus der DE 197 12 747 A1 ist ein Solarmodul bekannt, bei dem die Verbindungsleiter der Zellenstrings als Leiterbüschel über eine in die Innenplatte eingebrachte Öffnung zu einer außen auf dieser angeordneten externen Anschlußeinrichtung geführt werden. Zwar benötigt man bei dieser Modulanschlußtechnik lediglich eine einzige Öffnung (Bohrung) in: der Innenplatte. Als nachteilig haben sich aber das Hinausragen der Anschlußeinrichtung über die Innenplatte und die geringe mechanische Festigkeit der elektrischen Verbindung (keine Zugentlastung der aus dem Solarmodul heraustretenden Verbindungsleiter) herausgestellt. Problematisch ist bei diesem Solarmodul außerdem die Abdichtung der Öffnung in der Innenplatte zur gegenüber Umgebungseinflüssen empfindlichen Zwischenschicht. Im Falle von in situ zu polymerisierenden Zwischenschichten kann im übrigen die flüssige Monomer-Mischung aus der Öffnung austreten.

Die FR 2 362 494 A, nach der der Oberbegriff des Anspruches 1 gebildet wurde, offenbart ein photovoltaisches Solarmodul, bei dem mehrere Verbindungsleiter in Form von Runddrähten mit Anschlußkontakten fiir Solarzellen dauerhaft verbunden werden.

Die EP 0 855 750 A1 zeigt ein Kontaktgitter, das zum Verbinden von Solarzellen mit einer Steckverbinder benutzt wird.

Die EP 0 325 369 A2 offenbart einen Stecker, der in das Innere eine Photovoltaikmoduls versenkt ist.

Es ist demnach eine Aufgabe der vorliegenden Erfindung, das bekannte Solarmodul dahingehend zu verbessern, daß die Fertigungstechnik vereinfacht wird und daß die Bauhöhe des Solarmoduls gering gehalten werden kann. Das Solarmodul soll ohne Gefahr für die elektrische Anschlußeinrichtung handhabbar sein. Außerdem soll eine gute und einfach herstellbare Abdichtung der Öffnungen zur Zwischenschicht hin möglich sein.

Diese Aufgabe wird mit einem photovoltaischen Solarmodul nach Anspruch 1 gelöst. Vorteilhafte Ausgestaltungen sind Gegenstand der Unteransprüche.

Es ist vorgesehen, daß mehrere, bevorzugt alle Verbindungsleiter dauerhaft mit einer gemeinsamen Anschlußeinrichtung verbunden sind, die einen mehrpoligen Steckverbinder umfaßt. Der mehrpolige Steckverbinder wird dabei im Normalfall als Mehrfachbuchse ausgebildet sein, in die als externes Verbindergegenstück ein mehrere Einzelstecker aufweisender Mehrfachstecker einsteckbar ist. Es kann aber auch mit einem als Mehrfachstecker ausgebildeten Steckverbinder oder mit Mischformen aus Stecker und Buchse gearbeitet werden. Wichtig ist, daß der in einer Öffnung in der Innenplatte des Solarmoduls geschützt angeordnete Steckverbinder ermöglicht, das Solarmodul erst bei Bedarf an externe Schaltungsbestandteile anzuschließen, so daß bis dahin ein problemloses Hantieren mit dem Solarmodul bis zu dessen Einbau vor Ort möglich ist.

Eine gute Abdichtung und mechanische Stabilität des Anschlußbereichs des Solarmoduls ist erreicht, wenn der Steckverbinder mit seinen radialen Abmessungen im wesentlichen der Größe der Öffnung in der Innenplatte entspricht und wenn der Steckverbinder außerdem eine an der zum Modulinneren weisenden Oberfläche der Innenplatte zur Anlage kommende, sich bevorzugt über den gesamten Umfang der Öffnung erstreckende Anlageschulter aufweist, die größere radiale Abmessungen als die Öffnung hat. Mit einer solchen Konfiguration kann bereits eine fiir viele Zwecke ausreichende flüssigkeitsdichte Preßdichtung zwischen dem üblicherweise elastisch verformbaren Korpusmaterial des Steckverbinders und dem Umfangsrand der Öffnung in der Innenplatte erzielt werden.

Für die Einzelkontakte des Steckverbinders können übliche Materialien, wie Silber, Gold, Kupfer, Messing oder dergleichen gewählt werden. Die Abstände der Einzelkontakte (Buchsen, Steckerstifte) voneinander sind dabei so zu bemessen, daß sie ausreichend voneinander isoliert sind und daß beim Aufstecken des Verbindergegenstücks keine Kurzschlußgefahr besteht.

Bevorzugt sind die Verbindungsleiter des Solarmoduls mit den Einzelleitern eines in die Zwischenschicht eingebetteten flächigen Kontaktgitters dauerhaft verbunden und die Einzelleiter des Kontaktgitters an ihren entgegengesetzten Enden mit den Einzelkontakten des mehrpoligen Steckverbinders dauerhaft verbunden. Dies geschieht am besten dadurch, daß die Einzelkontakte des Steckverbinders mit ihren zum Modulinneren weisenden Fußflächen jeweils mit zumindest einem Einzelleiter des Kontaktgitters durch Löten oder Schweißen verbunden sind.

Fertigungstechnisch besonders vorteilhaft ist, daß eine industrielle Vorfertigung eines aus Kontaktgitter und mit diesem dauerhaft verbundenen Steckverbinder bestehenden Anschlußelements erfolgen kann. Der Steckverbinder dieses vorgefertigten Anschlußelements wird im Rahmen der Solarmodulfertigung von innen in die Öffnung der Innenplatte eingesteckt, wonach nur noch die Verbindungsleiter der Zellenstrings mit den Einzelleitern des Kontaktgitters durch Löten, Schweißen oder eine andere dauerhafte Verbindungstechnik verbunden werden müssen.

Das Kontaktgitter besteht vorzugsweise aus einem dünnen Blech, insbesondere aus verzinntem Kupfer, wobei dessen Einzelleiter durch das Herauslösen von Blechabschnitten zwischen den Einzelleitern, insbesondere durch Stanzen oder Ätzen, gebildet und voneinander separiert wurden. Dabei kann es je nach Länge des Kontaktgitters zur mechanischen Stabilisierung vorteilhaft sein, zwischen den Einzelleitern zunächst noch Brückenstege stehen zu lassen, die erst im Rahmen der Fertigstellung des Solarmoduls je nach Schaltungsanordnung entfernt werden, z. B. durch Stanzen. Die Dicke des Kontaktgitters beträgt bevorzugt weniger als etwa 0,5 mm, insbesondere etwa 0,2 mm.

Die Einzelleiter des Kontaktgitters verlaufen dabei mit gegenseitigem Abstand und normalerweise über den Großteil ihrer Längserstreckung parallel, wobei ihre dem Steckverbinder zugewandten Enden zu den Anschlußflächen hin jeweils in der Kontaktgitterebene abknicken, so daß die Anschlußflächen der Einzelleiter deckungsgleich mit den zugehörigen Einzelkontakten des Steckverbinders angeordnet sind. Das Kontaktgitter wirkt somit in gewisser Weise als Adapter zwischen der Anordnung der Anschlußstellen der meist geradlinigen Verbindungsleiter und der meist davon abweichenden Anordnung der Einzelkontakte des Steckverbinders. Das Anschließen der Verbindungsleiter an den Steckverbinder kann auf diese Weise erheblich vereinfacht werden gegenüber einem direkten Anschluß der Verbindungsleiter an die Einzelkontakte des Steckverbinders.

Insbesondere bei einem Einsatz einer Glasplatte als Innenplatte des Solarmoduls ist die den Steckverbinder aufnehmende Öffnung der Innenplatte bevorzugt als kreisförmige Bohrung und der Steckverbinder als zylindrische Trommel mit annähernd gleichem Durchmesser ausgeführt. Eine solche kreisförmige Bohrung ist vergleichsweise einfach in Glas einzubringen. In diesem Fall werden die Einzelkontakte des Steckverbinders mit besonderem Vorteil auf einem Kreis und im wesentlichen äquidistant an der zylindrischen Wand des Steckverbinders angeordnet. Auf diese Weise ist eine besonders wirksame gegenseitige Isolation der Einzelkontakte möglich.

Wird als Innenplatte eine Kunststoffplatte oder dergleichen verwendet, so sind auch andere, z.B. rechteckige, Öffnungsquerschnitte und entsprechend andere Steckverbinderquerschnitte denkbar.

Eine noch bessere Abdichtung auch gegen Gase wie Wasserdampf ist erreichbar, wenn zwischen der Anlageschulter und der Innenplatte eine (umlaufende) Dichtung angeordnet ist. Dazu kann ein vorgefertigter, auf die Anlageschulter auflegbarer Dichtring eingesetzt werden, oder aber die Dichtung wird unmittelbar auf die Anlageschulter aufgespritzt. Für die Dichtung haben sich doppelseitig klebende und kleine Höhenunterschiede ausgleichende Materialien auf Acrylbasis bewährt. Für den Fall, daß die Zwischenschicht des Solarmoduls in situ durch das Einfüllen und anschließende Polymerisieren einer niedrigviskosen flüssigen Monomer-Mischung gebildet wird, hat sich ein mit Preßpassung und Anlageschulter mit umlaufender Dichtung ausgeführter Steckverbinder bewährt. Dieser verschließt nach Art eines Stopfen gas- und flüssigkeitsdicht die Öffnung in der Innenplatte. Dadurch, daß die Anlageschulter des Steckverbinders nach dem Einstecken in die Öffnung an der der Zwischenschicht zugewandten Oberfläche der Innenplatte anliegt, wird diese Anlageschulter durch die bei der Herstellung eingebrachte Monomer-Mischung gegen die Innenplatte gedrückt, so daß ein automatischer Dichtungseffekt bei der Herstellung erzielt wird. Dieser Effekt kann bei Bedarf mit Hilfe einer aufschraubbaren Konterplatte verstärkt werden, die im Zuge der Herstellung des Solarmoduls dafür sorgt, daß die Anlageschulter gegen die Innenplatte gepreßt wird. Nach dem Aushärten des Materials kann die Konterplatte wieder entfernt werden. Die Breite der Anlageschulter sollte mindestens etwa 1mm, vorzugsweise 4 mm und mehr betragen.

Es liegt im Rahmen der Erfindung, den Steckverbinder konisch, d.h. sich nach außen hin verjüngend, auszugestalten und die Öffnung in der Innenplatte komplementär dazu auszuführen.

Sowohl die konische Gestaltung des Steckverbinders als auch das Vorsehen einer Anlageschulter sorgt für eine sichere mechanische Verankerung des Steckverbinders am Solarmodul, so daß dieser große Abreißkräfte ohne Schaden aufnehmen und auf die Innenplatte ableiten kann.

Der Steckverbinder wird bevorzugt so dimensioniert, daß er vollständig in der Öffnung der Innenplatte verschwindet und die äußere Oberfläche der Innenplatte nicht überragt. So ist er am besten vor mechanischen Beanspruchungen geschützt. Außerdem lassen sich auf diese Weise Solarmodule besser stapeln. Zu diesem Zweck beträgt die Höhe des Steckverbinders bevorzugt insgesamt nicht mehr als etwa 5 mm, bevorzugt etwa 3 mm.

Für die spätere Kontaktierung des Solarmoduls ist es vorteilhaft, wenn in den Korpus des Steckverbinders eine - vorzugsweise etwa mittig angeordnete - Gewindebuchse eingebettet ist, in die eine Fixierschraube zum Befestigen des zugehörigen externen Verbindergegenstücks eindrehbar ist. Auf diese Weise kann ein unbeabsichtigtes Lösen der Steckverbindung vermieden und eine besonders sichere und dauerhafte Kontaktierung des Steckverbinders mit seinem Verbindergegenstück erreicht werden.

Mit der erfindungsgemäßen Anschlußgestaltung des Solarmoduls gelingt es überraschenderweise, eine mit geringem Fertigungsaufwand herstellbare, stabile und robuste Anschlußeinrichtung mit äußerst geringer Bauhöhe zum elektrischen Verbinden von Solarmodulen bereitzustellen. Vorzugsweise ist die aus Steckerbuchse und Steckerteil bestehende Steckverbinderanordnung als zylindrische Trommel ausgeführt und weist eine der Anzahl der benötigten elektrischen Anschlüsse entsprechende Zahl an Buchsenkontakten und Kontaktstiften auf.

Es versteht sich, daß der Korpus des Steckverbinders aus einem elektrisch isolierenden Material bestehen muß. Die Isolationsfestigkeit dieser Materialien muß für Spannungen bis 150 V ausgelegt sein. Dabei ist die Verwendung elastisch verformbarer Kunststoffmaterialien insgesamt bevorzugt. Als geeignete Materialien für die Herstellung des Steckverbinder-Korpus haben sich insbesondere die folgenden Kunststoffe herausgestellt: Polycarbonat, Acrylnitril-Butadien-Styrol (ABS), Polyamid, Silikon und Flüssigkristallpolymere (LCP). Von diesen hat sich als ganz besonders geeignet ein Flüssigkristallpolymer auf Basis von 4-oxybenzoat-co-6-oxy-2-naphtoat (73:27) mit 30 Gew.-% Glasfaseranteil (Produktname Vectra, Hersteller Hoechst Celanese) herausgestellt. Dieses Material ist im für Solarmodule relevanten Temperaturbereich hinreichend stabil und insbesondere in den Fällen, in denen die Zwischenschicht des Solarmoduls aus einem in situ gebildeten, wenigstens ein (Meth-) Acrylsäureester, wenigstens einen Weichmacher und wenigstens einen Polymerisationsinitiator aufweisenden Kunststoff besteht, gur mit dem Zwischenschichtmaterial verträglich. Solche im Rahmen der Erfindung besonders bevorzugten Kunststoffzwischenschichten für Solarmodule sind beispielsweise Gegenstand der EP 0 683 215 A1.

Im folgenden soll die Erfindung anhand eines Ausführungsbeispiels und einer Zeichnung näher erläutert werden. Es zeigen:
- Figur 1: eine Draufsicht auf den Anschlußbereich eines Solarmoduls gemäß der Erfindung;
- Figur 2: eine Schnittansicht durch ein Solarmodul mit einer erfindungsgemäßen Anschlußeinrichtung (nicht maßstäblich) ähnlich demjenigen aus Figur 1;
- Figur 3: eine Draufsicht auf ein aus Kontaktgitter und Steckverbinder bestehendes vorgefertigtes Anschlußelement;
- Figur 4: eine Teildraufsicht auf die Unterseite des vorgefertigten Anschlußelements gemäß Figur 4; und
- Figur 5: eine perspektivische Darstellung eines im Anschlußbereich aufgeschnittenen erfindungsgemäßen Solarmoduls mit zugeordnetem Verbindergegenstück.

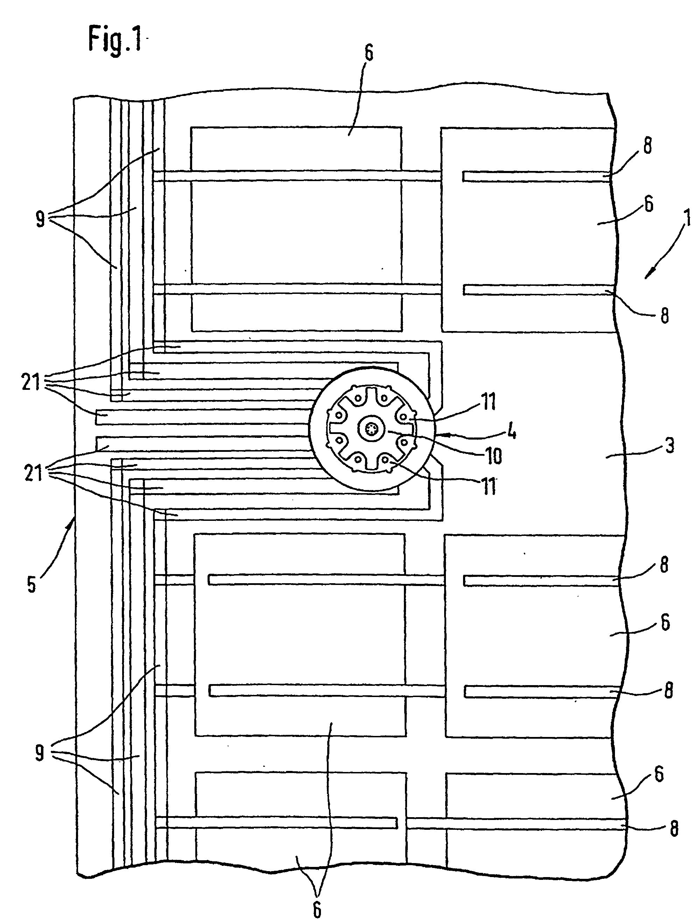

Figur 1 zeigt in schematischer Darstellung den Anschlußbereich eines erfindungsgemäßen Solarmoduls 1 in der Draufsicht auf dessen im Einbauzustand von der Sonne abgewandte Innenplatte 3. Die Innenplatte 3 besteht im dargestellten Beispiel aus 4 mm dickem Floatglas. Das Solarmodul 1 umfaßt eine Vielzahl einzelner Solarzellen 6, die gruppenweise zu sogenannten Zellenstrings zusammengefaßt sind. In der Figur 1 erkennbar sind Teile dreier solcher Zellenstrings. Zu einem Zellenstring gehören jeweils zwei langgestreckte erste Verbindungsleiter 8 aus verzinntem Kupfer, die mit Hilfe nicht dargestellter kurzer Anschlußleiter mit den Solarzellen 6 verbunden sind. Die ersten Verbindungsleiter 8 verbinden die einzelnen Solarzellen 6 elektrisch und mechanisch untereinander. Sie haben typischerweise eine Breite von höchstens etwa 2 mm, um die Solarzellen 6 so wenig wie möglich abzuschatten.

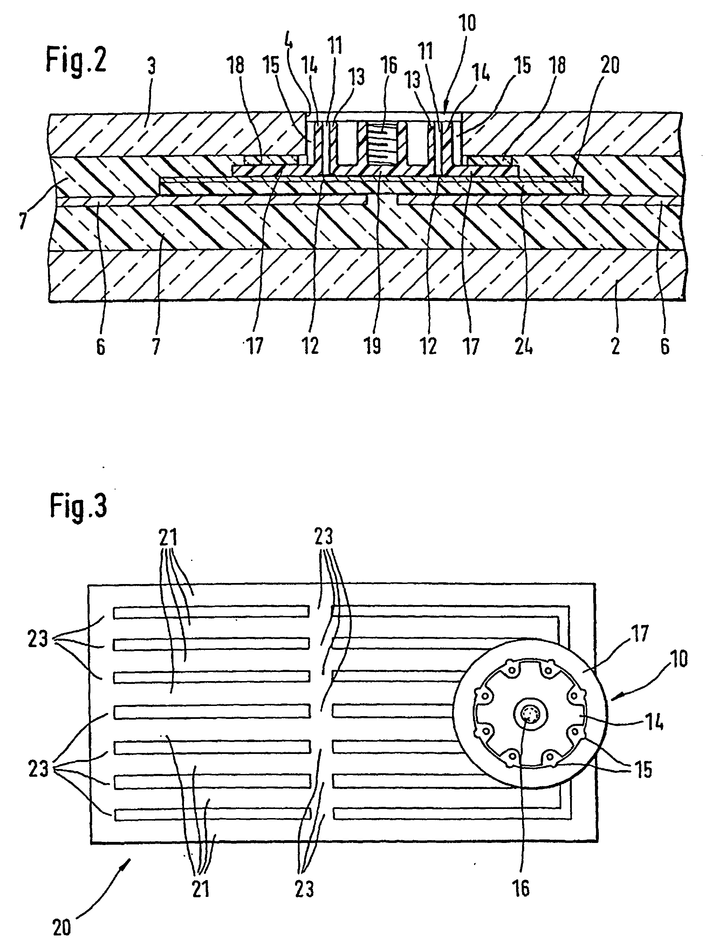

Die bis in die Nähe des Modulrands 5 verlaufenden ersten Verbindungsleiter 8 sind mit in etwa parallel zum Modulrand 5 verlaufenden zweiten Verbindungsleitern 9 verlötet, die die Zellenstrings mit der Anschlußeinrichtung des Solarmoduls 1 verbinden. Diese zweiten Verbindungsleiter 9 können zur Minimierung von Leitungsverlusten breiter als die ersten Verbindungsleiter 8 sein, da sie außerhalb der Solarzellen 6 verlaufen. In der Praxis arbeitet man z.B. mit 5 mm breiten zweiten Verbindungsleitem 9. Die Anschlußeinrichtung umfaßt einen in einer Bohrung 4 in der Innenplatte 3 angeordneten mehrpoligen Steckverbinder 10, der im dargestellten Fall acht als Buchsen ausgeführte Einzelkontakte 11 aufweist. Sechs dieser Einzelkontakte 11 sind über Einzelleiter 21 mit den zweiten Verbindungsleitern 9 verbunden. Die mittleren Einzelleiter 21 und damit die zugehörigen Einzelkontakte 11 des Steckverbinders 10 werden im dargestellten Ausführungsbeispiel nicht genutzt. An sie könnten bei Bedarf weitere Zellenstrings angeschlossen werden. Zur deutlicheren Darstellung ist der Steckverbinder 10 und sind die Einzelleiter 21 in Figur 1 zwischen den Solarzellen 6 angeordnet. In der Praxis wird man, wie in der folgenden Figur 2 erkennbar wird, zur bestmöglichen Ausnutzung der Modulfläche zur Energiegewinnung die Solarzellen 6 auch im Anschlußbereich möglichst dicht beieinander anordnen und die Anschlußeinrichtung von der Innenplatte 3 aus gesehen oberhalb der Solarzellen 6 positionieren.

Die Einzelleiter 21 sind entsprechend einer weiter unten näher erläuterten besonders bevorzugten Ausführungsform der Erfindung als mit den zweiten Verbindungsleitern 9 verlötete oder verschweißte gesonderte Leiter gestaltet. Es liegt aber im Rahmen der Erfindung, auf solche gesonderten Leiter zu verzichten und die ersten Verbindungsleiter 8 und/oder die zweiten Verbindungsleiter 9 direkt mit den Einzelkontakten 11des Steckverbinders 10 zu verbinden.

Figur 2 stellt einen Querschnitt eines erfindungsgemäßen Solarmoduls 1 dar, das ähnlich demjenigen in Figur 1 ist, bei dem aber - wie zuvor schon erläutert - die Solarzellen 6 mit geringerem Abstand angeordnet sind. Zu Vereinfachung der Darstellung wurden außerdem die ersten und zweiten Verbindungsleiter 8, 9 weggelassen. Zu erkennen sind die im Einbauzustand der Sonne zugewandte, ebenfalls aus 4 mm dickem Floatglas bestehende Außenplatte 2, die Innenplatte 3 sowie die beide Platten 2, 3 verbindende und die Solarzellen 6 einbettende Zwischenschicht 7, die im Ausführungsbeispiel aus einem in situ polymerisierten transparenten Kunststoff auf Basis eines Acrylsäureesters besteht.

In eine Bohrung 4 in der Innenplatte 3 mit einem Durchmesser von 24 mm ist ein Steckverbinder 10 eingesetzt, dessen radiale Abmessungen an den Durchmesser der Bohrung 4 angepaßt sind, so daß der Steckverbinder 10 nach Art einer Preßpassung fest in der Bohrung 4 sitzt. Der aus einem Flüssigkristallpolymer (LCP) bestehende Korpus des Steckverbinders 10 weist eine Topfform mit zylindrischer Wand 14 und mit kreisförmiger Bodenfläche 19 auf. Zur Erzielung der angestrebten Preßpassung ist der Außendurchmesser der Wand 14 geringfügig kleiner als der Durchmesser der Bohrung 4 und sind zusätzlich über den Außenumfang der Wand 14 verteilte Passungsrippen 15 vorgesehen, die sich beim Eindrücken des Steckverbinders 10 in die Bohrung 4 elastisch verformen und den Steckverbinder 10 dadurch mechanisch fixieren.

Die Bodenfläche 19 des Steckverbinders 10 ist über die Wand 14 hinaus verlängert und bildet dort eine etwa 5 mm breite Anlageschulter 17, mit deren Hilfe der Steckverbinder 10 gesichert wird. Aufgrund der zuvor erwähnten Preßpassung kann bereits mit Hilfe dieser Anlageschulter 17, die fest an der zur Zwischenschicht 7 gewandten Oberfläche der Innenplatte 3 anliegt, eine für viele Fälle ausreichende flüssigkeitsdichte Abdichtung der Bohrung 4 erreicht werden. Zur Verbesserung der Abdichtung und zur Erzielung einer guten Gasdichtigkeit ist im dargestellten Ausführungsbeispiel allerdings eine zusätzliche ringförmige Dichtung 18 auf Acrylbasis zwischen der Anlageschulter 17 und der Innenplatte 3 angeordnet, die beim Aufbringen auf die Anlageschulter 17 etwa 250 µm dick und etwa 3 mm breit ist.

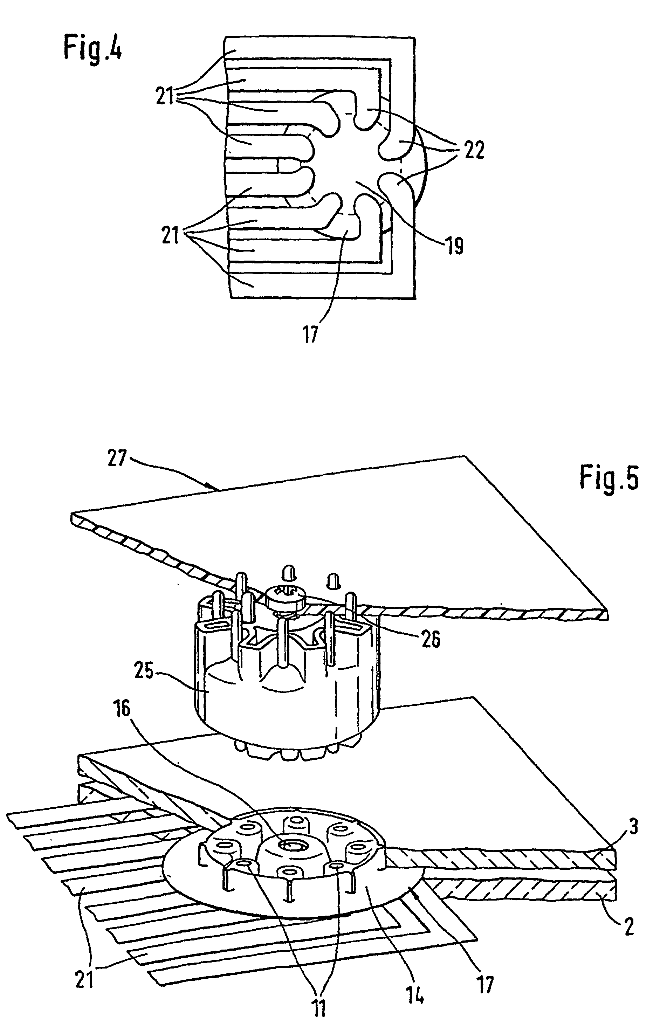

In der Nähe der Wand 14 des Steckverbinders 10 sind in Buchsenmäntel 13 eingebettete, als Buchsen ausgebildete Einzelkontakte 11 angeordnet, die zum späteren Anschluß des Solarmoduls 1 mit Hilfe eines als Mehrfachstecker ausgebildeten, in Figur 5 skizzierten Verbindergegenstücks 25 dienen. Die mittig im Steckverbinder 10 angeordnete, in dessen Korpus eingelassene Gewindebuchse 16 dient im Einbauzustand zur Fixierung dieses Verbindergegenstücks 25 mit Hilfe einer Fixierschraube 26 (s. Figur 5). Anstelle von Buchsen könnten auch Stecker als Einzelkontakte 11 des Steckverbinders 10 und ein als Mehrfachbuchse gestaltetes Verbindergegenstück verwendet werden. Die Fußflächen 12 der Einzelkontakte 11 sind mit einem weiter unten näher erläuterten Kontaktgitter 20 dauerhaft verbunden, bevorzugt durch Schweißen oder Löten. Zwischen dem Kontaktgitter 20 und den Solarzellen 6 ist ein Isolierstreifen 24 aus dem gleichen Material und in gleicher Dicke wie die Dichtung 18 angeordnet, der für eine elektrische Isolierung der Anschlußeinrichtung gegen die Solarzellen 6 sorgt und außerdem bei der Modulherstellung als Abstandhalter wirkt.

Wie deutlich erkennbar ist, liegt der obere Rand des Steckverbinders 10 ein Stück weit unterhalb der äußeren Oberfläche der Innenplatte 3, so daß er beim Hantieren des Solarmoduls 1 geschützt ist. Das noch nicht an die Peripherie angeschlossene Solarmodul 1 hat hierdurch außerdem eine sehr geringe Bauhöhe und kann problemlos im Stapel gelagert und transportiert werden. Der Steckverbinder 10 verschließt mit seiner Bodenfläche 19, der Anlageschulter 17 sowie der Dichtung 18 die Bohrung 4 in der Innenplatte 3 so dicht, daß eine zur Bildung der Zwischenschicht 7 verwendete niedrigviskose Monomer-Mischung nicht hinausfließen kann und daß außerdem die Zwischenschicht 7 im Einbauzustand gut gegen Umgebungseinflüsse, insbesondere gegen das Eindringen von Wasserdampf, geschützt ist.

Figur 3 und Figur 4 zeigen ein aus dem Steckverbinder 10 und einem Kontaktgitter 20 gebildetes Anschlußelement, das im Rahmen der Erfindung ganz bevorzugt als vorgefertigtes, universell einsetzbares Bauteil zum Einsatz kommt. Der dargestellte Steckverbinder 10 entspricht demjenigen aus den vorherigen Figuren. Deutlicher als in Figur 3 erkennbar sind die zylindrische Wand 14, die in Buchsenmäntel 13 eingebetteten Einzelkontakte (Buchsen) 11 sowie die am Außenumfang der Wand 14 jeweils den Einzelkontakten 11 gegenüberliegend angeordneten Passungsrippen 15.

In Figur 3 vollständig und in Figur 4 ausschnittsweise dargestellt ist ein aus einem etwa 200 um dicken verzinnten Kupferblech durch Ausstanzen geformtes Kontaktgitter 20, das im Ausführungsbeispiel acht über den Großteil ihrer Länge parallel verlaufende Einzelleiter 21 umfaßt. Um eine möglichst universelle Einsetzbarkeit des Anschlußelements zu gewährleisten, haben die Einzelleiter 21 eine Gesamtlänge, die der größten im konkreten Einzelfall benötigten Länge entspricht. Sie werden dann vor dem Einsatz im Solarmodul 1 passend zugeschnitten. Außerdem sind die Einzelleiter 21 zunächst an ihren dem Steckverbinder 10 abgewandten Enden sowie etwa in ihrer Mitte durch Brückenstege 23 miteinander verbunden, die je nach Bedarf ebenfalls vor dem Einsatz zum Beispiel durch Stanzen entfernt werden können, so wie dies in Figur 1 erkennbar ist. Die Einzelleiter 21 des Kontaktgitters 20 knicken im Bereich des Steckverbinders 10 in der Kontaktgitterebene ab, so daß ihre zum Anschluß an die Einzelkontakte 11 des mehrpoligen Steckverbinders 10 dienenden verzinnten Anschlußflächen 22 deckungsgleich mit den kreisförmig angeordneten, in diesen Figuren nicht dargestellten Fußflächen 12 der Einzelkontakte 11 zu liegen kommen. Das Kontaktgitter 20 übernimmt bei dem erfindungsgemäßen Solarmodul 1 die Funktion eines universellen Adapters, das den Anschluß der ersten und/oder zweiten Verbindungsleiter 8, 9 an den Steckverbinder 10 erleichtert und das die Verwendung des aus Steckverbinder 10 und Kontaktgitter 20 bestehenden, industriell vorfertigbaren Anschlußelements fiir eine Vielzahl von verschiedenen Solarmodulen 1 zuläßt. Dabei wird man die Zahl der Einzelkontakte 11 und Einzelleiter 21 möglichst groß wählen und im konkreten Einzelfall so viele Einzelkontakte 11 des Steckverbinders 10 wie erforderlich an die Solarzellen 6 anschließen.

Figur 5 zeigt schließlich in perspektivischer Darstellung den teilweise aufgeschnittenen Anschlußbereich eines erfindungsgemäßen Solarmoduls 1 mit einem über dem Steckverbinder 10 positionierten Verbindergegenstück 25. Das Verbindergegenstück 25 wird nach dem Einstecken in den Steckverbinder 10 mit Hilfe einer Fixierschraube 26, die in die Gewindebuchse 16 eingedreht wird, arretiert, so daß eine dauerhaft gute Kontaktierung der Einzelkontakte 11 mit den Einzelsteckern des Verbindergegenstücks 25 sowie eine Sicherung gegen ein versehentliches Trennen der Verbindung erreicht wird. In der Figur 5 ist außerdem eine Platine 27 erkennbar, die mit externen Schaltungselementen wie z.B. Dioden, Wechselrichtern und dergleichen versehen werden kann. Der Übersichtlichkeit halber weggelassen wurden weitere Bestandteile des Solarmoduls 1 wie Solarzellen 6, Zwischenschicht 7 etc.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

### BEZUGSZEICHENLISTE

- 1: Solarmodul
- 2: Außenplatte
- 3: Innenplatte
- 4: Öffnung (Bohrung) in der Innenscheibe
- 5: Modulrand
- 6: Solarzellen
- 7: Zwischenschicht
- 8: erste Verbindungsleiter
- 9: zweite Verbindungsleiter

- 10: Steckverbinder
- 11: Einzelkontakte (Buchsen)
- 12: Fußflächen der Einzelkontakte
- 13: Buchsenmantel
- 14: Wand des Steckverbinders
- 15: Passungsrippen
- 16: Gewindebuchse
- 17: Anlageschulter
- 18: Dichtung
- 19: Bodenfläche des Steckverbinders

- 20: Kontaktgitter
- 21: Einzelleiter des Kontaktgitters
- 22: steckverbinderseitige Anschlußflächen
- 23: Brückenstege
- 24: Isolierstreifen

- 25: Verbindergegenstück
- 26: Fixierschraube
- 27: Platine

## Patentansprüche

1. Photovoltaisches Solarmodul in Plattenform, mit einer Außenplatte (2), einer Innenplatte (3) und einer diese verbindenden Zwischenschicht (7) aus Kunststoff, in der Solarzellen (6) eingebettet sind, wobei die Solarzellen (6) über mehrere Verbindungsleiter (8, 9) elektrisch miteinander verschaltet sind und wobei die Verbindungsleiter (8, 9) dauerhaft jeweils mit einer in einer Öffnung in der Innenplatte (3) angeordneten mehrpoligen Steckverbinder elektrisch leitend verbunden sind, wobei der Steckverbinder (10) mit seinen radialen Abmessungen im wesentlichen der Größe der Öffnung (4) in der Innenplatte (3) entspricht
**dadurch gekennzeichnet,**
**daß** der Steckverbinder (10) eine an der zum Modulinneren weisenden Oberfläche der Innenplatte (3) zur Anlage kommende Anlageschulter (17) aufweist, die größere radiale Abmessungen als die Öffnung (4) hat und die sich über den gesamten Umfang der Öffnung (4) erstreckt.

2. Photovoltaisches Solarmodul nach Anspruch 1, **dadurch gekennzeichnet, daß** die Verbindungsleiter (8, 9) mit den Einzelleitern (21) eines in die Zwischenschicht (7) eingebetteten flächigen Kontaktgitters (20) dauerhaft verbunden sind und daß die Einzelleiter (21) des Kontaktgitters (20) an ihren entgegengesetzten Enden mit ihren Anschlußflächen (22) mit den Einzelkontakten (11) des mehrpoligen Steckverbinders (10) dauerhaft verbunden sind.

3. Photovoltaisches Solarmodul nach Anspruch 2, **dadurch gekennzeichnet, daß** die Einzelkontakte (11) des Steckverbinders (10) mit ihren zum Modulinneren weisenden Fußflächen (12) jeweils mit zumindest einem Einzelleiter (21) des Kontaktgitters (20) durch Löten oder Schweißen verbunden sind.

4. Photovoltaisches Solarmodul nach Anspruch 2 oder 3, **dadurch gekennzeichnet, daß** das Kontaktgitter (20) aus einem dünnen Blech, insbesondere aus verzinntem Kupfer, mit einer Dicke unter 0,5 mm besteht, wobei dessen Einzelleiter (21) durch das Herauslösen von Blechabschnitten zwischen den Einzelleitern (21) gebildet und voneinander separiert wurden.

5. Photovoltaisches Solarmodul nach einem der Ansprüche 2 bis 4, **dadurch gekennzeichnet, daß** die Einzelleiter (21) des Kontaktgitters (20) mit gegenseitigem Abstand und über den Großteil ihrer Längserstreckung parallel verlaufen, wobei ihre dem Steckverbinder (10) zugewandten Enden zu den Anschlußflächen (22) hin jeweils in der Kontaktgitterebene abknicken, so daß die Anschlußflächen (22) der Einzelleiter (21) deckungsgleich mit den zugehörigen Einzelkontakten (11) des Steckverbinders (10) angeordnet sind.

6. Photovoltaisches Solarmodul nach einem der vorherigen Ansprüche, **dadurch gekennzeichnet, daß** die Öffnung (4) in der Innenplatte (3) als kreisförmige Bohrung und daß der Steckverbinder (10) als zylindrische Trommel mit annähernd gleichem Durchmesser ausgeführt ist.

7. Photovoltaisches Solarmodul nach Anspruch 6, **dadurch gekennzeichnet, daß** die Einzelkontakte (11) des Steckverbinders (10) auf einem Kreis und im wesentlichen äquidistant benachbart zu der zylindrischen Wand (14) des Steckverbinders (10) angeordnet sind.

8. Photovoltaisches Solarmodul nach Anspruch 1, **dadurch gekennzeichnet, daß** zwischen der Anlageschulter (17) und der Innenplatte (3) eine Dichtung (18) angeordnet ist.

9. Photovoltaisches Solarmodul nach einem der vorherigen Ansprüche, **dadurch gekennzeichnet, daß** der Steckverbinder (10) die äußere Oberfläche der Innenplatte (3) nicht überragt.

10. Photovoltaisches Solarmodul nach einem der vorherigen Ansprüche, **dadurch gekennzeichnet, daß** in den Korpus des Steckverbinders (10) eine - vorzugsweise etwa mittig angeordnete - Gewindebuchse (16) eingebettet ist, in die eine Fixierschraube (26) zum Befestigen des zugehörigen externen Verbindergegenstücks (25) eindrehbar ist.

11. Photovoltaisches Solarmodul nach einem der vorherigen Ansprüche, **dadurch gekennzeichnet, daß** der Korpus des Steckverbinders (10) aus einem elektrisch isolierenden Kunststoff, vorzugsweise aus Polycarbonat, Acrylnitril-Butadien-Styrol (ABS), Polyamid, Silikon oder einem Flüssigkristallpolymer (LCP), besteht.

12. Photovoltaisches Solarmodul nach Anspruch 14, **dadurch gekennzeichnet, daß** der Korpus des Steckverbinders (10) aus einem im Temperaturbereich von -40°C bis +120°C stabilen Flüssigkristallpolymer (LCP) besteht.

13. Photovoltaisches Solarmodul nach einem der vorherigen Ansprüche, **dadurch gekennzeichnet, daß** die Zwischenschicht (7) eine transparente Polymerschicht ist, insbesondere auf Basis eines (Meth-) Acrylsäureesters.

## Claims

1. A photovoltaic solar module in panel form, with an outer panel (2), an inner panel (3), and an intermediate layer (7) of plastic which connects the outer and inner panels and in which solar cells (6) are embedded, the solar cells (6) being electrically interconnected via a plurality of connecting conductors (8, 9) and the connecting conductors (8, 9) being permanently electrically conductively connected in each case to a multi-pole plug connector disposed in an opening in the inner panel (3), the radial dimensions of the plug connector (10) corresponding substantially to the size of the opening (4) in the inner panel (3), **characterised in that** the plug connector (10) comprises an abutment shoulder (17) which comes into abutment with the surface of the inner panel (3) facing the module interior, said shoulder (17) having larger radial dimensions than the opening (4) and extending over the entire periphery of the opening (4).

2. A photovoltaic solar module according to claim 1, **characterised in that** the connecting conductors (8, 9) are permanently connected to the individual conductors (21) of a flat contact grid (20) embedded in the intermediate layer (7) and **in that** the individual conductors (21) of the contact grid (20) are permanently connected, at their opposite ends, by their connecting surfaces (22), to the individual contacts (11) of the multi-pole plug connector (10).

3. A photovoltaic solar module according to claim 2, **characterised in that** the individual contacts (11) of the plug connector (10) are each connected by their foot surfaces (12) facing the module interior to at least one individual conductor (21) of the contact grid (20) by soldering or welding.

4. A photovoltaic solar module according to claim 2 or 3, **characterised in that** the contact grid (20) consists of a thin metal sheet, more particularly tin-plated copper, having a thickness of less than 0.5 mm, its individual conductors (21) being formed and separated from one another by the removal of sheet portions between the individual conductors (21).

5. A photovoltaic solar module according to any one of claims 2 to 4, **characterised in that** the individual conductors (21) of the contact grid (20) extend with mutual spacing and in parallel relationship over the majority of their length, while their ends which face the plug connector (10) are respectively bent off towards the connecting surfaces (22) in the contact grid plane so that the connecting surfaces (22) of the individual conductors (21) are disposed so as to coincide with the associated individual contacts (11) of the plug connector (10).

6. A photovoltaic solar module according to any one of the preceding claims, **characterised in that** the opening (4) in the inner panel (3) is formed as a circular bore and **in that** the plug connector (10) is formed as a cylindrical drum having approximately the same diameter.

7. A photovoltaic solar module according to claim 6, **characterised in that** the individual contacts (11) of the plug connector (10) are disposed over a circle and substantially equidistant adjacent the cylindrical wall (14) of the plug connector (10).

8. A photovoltaic solar module according to claim 1, **characterised in that** a seal (18) is disposed between the abutment shoulder (17) and the inner panel (3).

9. A photovoltaic solar module according to any one of the preceding claims, **characterised in that** the plug connector (10) does not project beyond the outer surface of the inner panel (3).

10. A photovoltaic solar module according to any one of the preceding claims, **characterised in that** a preferably substantially centrally disposed screwthreaded bush (16) is embedded in the body of the plug connector (10) and into it can be rotated a fixing screw (26) for fixing the associated external connector counterpart (25).

11. A photovoltaic solar module according to any one of the preceding claims, **characterised in that** the body of the plug connector (10) consists of an electrically insulating plastic, preferably polycarbonate, acrylonitrile-butadiene-styrene (ABS), polyamide, silicone or a liquid crystal polymer (LCP).

12. A photovoltaic solar module according to claim 14, **characterised in that** the body of the plug connector (10) consists of a liquid crystal polymer (LCP) which is stable in a temperature range from -40°C to +120°C.

13. A photovoltaic solar module according to any one of the preceding claims, **characterised in that** the intermediate layer (7) is a transparent polymer layer, more particularly a (meth)acrylic acid ester based polymer layer.

## Revendications

1. Module solaire photovoltaïque en forme de plaque, comportant une plaque externe (2), une plaque interne (3) et une couche intermédiaire (7) en matière plastique, reliant celles-ci, dans laquelle des cellules solaires (6) sont logées, ces cellules solaires (6) étant connectées électriquement les unes aux autres par plusieurs conducteurs de liaison (8, 9) et les conducteurs de liaison (8, 9) étant reliés de manière permanente et électriquement conductrice, chacun avec un connecteur multipolaire disposé dans une ouverture dans la plaque interne (3), le connecteur (10) correspondant, par ses dimensions radiales, pour l'essentiel à la grandeur de l'ouverture (4) de la plaque interne (3),
**caractérisé en ce**
**que** le connecteur (10) présente un épaulement de butée (17) venant en appui sur la surface, dirigée vers l'intérieur du module, de la plaque interne (3), lequel a des dimensions radiales plus grandes que l'ouverture (4) et s'étend sur toute la périphérie de l'ouverture (4).

2. Module solaire photovoltaïque selon la revendication 1, **caractérisé en ce que** les conducteurs de liaison (8, 9) sont reliés de manière permanente avec les conducteurs individuels (21) d'une grille de contact (20) plane logée dans la couche intermédiaire (7) et **en ce que** les conducteurs individuels (21) de la grille de contact (20) sont reliés de manière permanente par leurs faces de raccordement (22), à leurs extrémités opposées, aux contacts individuels (11) du connecteur multipolaire (10).

3. Module solaire photovoltaïque selon la revendication 2, **caractérisé en ce que** les contacts individuels (11) du connecteur (10) sont reliés, par leurs surfaces inférieures (12) dirigées vers l'intérieur du module, chacun avec au moins un conducteur individuel (21) de la grille de contact (20) par brasage ou soudage.

4. Module solaire photovoltaïque selon la revendication 2 ou 3, **caractérisé en ce que** la grille de contact (20) est constituée d'une tôle mince, en particulier en cuivre étamé, d'une épaisseur inférieure à 0,5 mm, ses conducteurs individuels (21) ayant été formés en enlevant des parties de tôle entre eux et en les séparant les uns des autres.

5. Module solaire photovoltaïque selon l'une des revendications 2 à 4, **caractérisé en ce que** les conducteurs individuels (21) de la grille de contact (20) sont disposés parallèlement à distance l'un de l'autre et sur la majeure partie de l'étendue de leur longueur, leurs extrémités dirigées vers le connecteur (10) se repliant vers les faces de raccordement (22), chacune dans le plan de la grille de contact, si bien que les faces de raccordement (22) des conducteurs individuels (21) sont disposées en recouvrant exactement les contacts individuels (11) correspondants du connecteur (10).

6. Module solaire photovoltaïque selon l'une des revendications précédentes, **caractérisé en ce que** l'ouverture (4) dans la plaque interne (3) est réalisée en tant que perçage de forme circulaire et **en ce que** le connecteur (10) l'est en tant que tambour cylindrique avec un diamètre approximativement identique.

7. Module solaire photovoltaïque selon la revendication 6, **caractérisé en ce que** les contacts individuels (11) du connecteur (10) sont disposés sur un cercle et essentiellement équidistants adjacents, à la paroi cylindrique (14) du connecteur (10).

8. Module solaire photovoltaïque selon la revendication 1, **caractérisé en ce qu'**une garniture d'étanchéité (18) est disposée entre l'épaulement de butée (17) et la plaque interne (3).

9. Module solaire photovoltaïque selon l'une des revendications précédentes, **caractérisé en ce que** le connecteur (10) ne dépasse pas de la surface extérieure de la plaque interne (3).

10. Module solaire photovoltaïque selon l'une des revendications précédentes, **caractérisé en ce que** dans le corps du connecteur (10) est logé un manchon fileté (16) - de préférence disposé approximativement au centre - dans lequel une vis de fixation (26) peut être engagée à rotation pour fixer le contre-élément (25) externe correspondant du connecteur.

11. Module solaire photovoltaïque selon l'une des revendications précédentes, **caractérisé en ce que** le corps du connecteur (10) est constitué d'une matière plastique électriquement isolante, de préférence en polycarbonate, acrylonitrile-butadiène-styrène (ABS), polyamide, silicone ou d'un polymère à cristaux liquides (LCP).

12. Module solaire photovoltaïque selon la revendication 14, **caractérisé en ce que** le corps du connecteur (10) est constitué d'un polymère à cristaux liquides (LCP), stable dans la gamme de température de -40°C à +120°C.

13. Module solaire photovoltaïque selon l'une des revendications précédentes, **caractérisé en ce que** la couche intermédiaire (7) est une couche de polymère transparente, en particulier à base d'un ester d'acide (méth-) acrylique.
